# EUROPÄISCHE PATENTSCHRIFT

(11) **EP 4 075 496 B1**
(45) Veröffentlichungstag und Bekanntmachung des Hinweises auf die Patenterteilung: **27.09.2023**
(21) Anmeldenummer: 22000092.1
(22) Anmeldetag: 01.04.2022
(51) Int. Cl.: H01L 23/473, H01L 23/433, H01L 23/495

(54) **GEHÄUSTES HALBLEITERBAUTEIL**
HOUSED SEMICONDUCTOR DEVICE
COMPOSANT SEMI-CONDUCTEUR LOGÉ DANS UN BOITIER

(30) Priorität: 15.04.2021 DE 102021001968
(43) Veröffentlichungstag der Anmeldung: 19.10.2022
(73) Patentinhaber: 3-5 Power Electronics GmbH, 01217 Dresden (DE)
(72) Erfinder: Kowalsky, Jens, 15859 Storkow (DE)
(74) Vertreter: Koch Müller Patentanwaltsgesellschaft mbH

(56) Entgegenhaltungen:
- EP-A1- 0 901 166
- WO-A1-2015/086184
- JP-A- 2002 270 748

## Beschreibung

Die Erfindung betrifft ein gehäustes Halbleiterbauteil aufweisend einen Kühlkörper und mindestens einen Die.

Gehäuste Halbleiterbauteile offenbart beispielsweise in der DE 103 45 419 A1 sind dem Fachmann bekannt.

Auch ist dem Fachmann geläufig, dass gerade im Bereich der Leistungselektronik das Kühlen der Halbleiterbauteile notwendig ist. Aus der EP 2 061 078 A1 ist beispielsweise eine Kühlkörperanordnung für ein Halbleiterbauelement bekannt, wobei der Kühlkörper eine Montagefläche mit einem an das Halbleiterbauelement angepassten thermischen Ausdehnungskoeffizienten aufweist. Auch aus der WO 2015 086 184 A1, der EP 0 901 166 A1 und der JP 2002 270748 A sind weitere Kühlkörperanordnungen bekannt.

Vor diesem Hintergrund besteht die Aufgabe der Erfindung darin, eine Vorrichtung anzugeben, die den Stand der Technik weiterbildet. Insbesondere wird ein besonders kompakter Aufbau vorgeschlagen, der gleichzeitig auch mechanische Belastungen der Halbleiterbauelemente reduziert.

Die Aufgabe wird durch ein gehäustes Halbleiterbauteil mit den Merkmalen des Patentanspruchs 1 gelöst. Vorteilhafte Ausgestaltungen der Erfindung sind Gegenstand von Unteransprüchen.

In dem Gegenstand der Erfindung wird ein gehäustes Halbleiterbauteil mit einen Kühlkörper bereitgestellt, wobei der Kühlkörper eine Oberseite, eine Unterseite, die Oberseite mit der Unterseite verbindende Seitenflächen und eine innerhalb des Kühlkörpers verlaufenden Kühlstruktur mit einer Zulaufleitung sowie einer Ablaufleitung für ein Kühlmedium aufweist und aus einem elektrisch leitfähigen Material mit einem ersten thermischen Ausdehnungskoeffizienten an der Oberseite und einem zweiten thermischen Ausdehnungskoeffizienten an der Unterseite besteht.

Auf der Oberseite und / oder der Unterseite des Kühlkörpers ist jeweils ein Die angeordnet und elektrisch leitfähig mit dem Kühlkörper verbunden. Der thermische Ausdehnungskoeffizient der Oberseite und der Unterseite des Kühlkörpers entspricht jeweils dem thermischen Ausdehnungskoeffizienten des darauf angeordneten Dies. Es sei angemerkt, dass mit dem Begriff entspricht ein Unterschied zwischen den beiden Ausdehnungskoeffizienten kleiner als 5% oder kleiner als 8% umfasst ist.

In einer Weiterbildung sind die beiden Ausdehnungskoeffizienten genau gleich groß.

In einer Weiterbildung ist der Ausdehnungskoeffizient auf der Unterseite bzw. auf der Oberseite des Kühlkörpers genau gleich wie der Ausdehnungskoeffizient des jeweiligen Dies.

Vorzugsweise weicht der thermische Ausdehnungskoeffizient der Oberseite und der Unterseite des Kühlkörpers von dem thermischen Ausdehnungskoeffizienten um höchstens 10% oder um höchstens 20% des darauf angeordneten Dies ab.

Der Kühlkörper ist mit einer der Seitenflächen an einem elektrisch isolierenden Träger befestigt, wobei an dem Träger zwei elektrisch leitfähige Anschlusspins befestigt sind und der Kühlkörper mit den Dies und einem Teil der Anschlusspins von einer Vergussmasse umschlossen sind. Es versteht sich, dass die beiden Anschlusspins gegeneinander elektrisch isoliert sind.

Es sei angemerkt, dass der Kühlkörper in einer Weiterbildung eine blockförmige Ausbildung aufweist. Vorzugsweise weisen die Oberseite und die Unterseite eine viereckige, vorzugsweise eine quadratische oder rechteckige Ausbildung aus.

In einer anderen Weiterbildung sind die Flächen des Kühlkörpers der Oberseite und der Unterseite gleich groß oder unterschiedlich groß. Hierbei ist die Fläche an der Oberseite größer als die Fläche an der Unterseite oder die Fläche an der Unterseite ist größer als die Fläche an der Oberseite. Vorzugsweise ist die Fläche an der Oberseite und die Fläche an der Unterseite jeweils insgesamt plan und / oder zueinander parallel ausgebildet.

In einer anderen Weiterbildung weisen die Seitenflächen des Kühlkörpers eine viereckige, vorzugsweise eine rechteckige oder eine quadratische Ausbildung aus. In einer Weiterbildung sind jeweils zwei der insgesamt vier Seitenflächen entgegengesetzt zueinander ausgebildet sind. In einer Ausführungsform sind alle vier Seitenflächen gleich groß oder unterschiedlich groß oder zumindest sind die beiden sich jeweils gegenüberliegenden Seitenflächen gleich groß oder unterschiedlich groß ausgebildet.

In einer anderen Ausführungsform sind die alle vier Seitenflächen oder zumindest zwei oder drei der Seitenflächen jeweils insgesamt plan ausgeformt. In einer Weiterbildung sind die Seitenflächen jeweils paarweise zueinander parallel ausgebildet.

In einer anderen Weiterbildung ist die Größe der Seitenflächen jeweils kleiner als die Größe der Oberseite oder die Größe der Unterseite ausgebildet. Vorzugsweise liegt die Größe der Seitenfläche in einem Bereich zwischen 80% und 10% oder in einem Bereich zwischen 50% und 20% der Größe der Fläche an der Oberseite oder der Fläche an der Unterseite.

Es versteht sich, dass genau eine, d.h. ausschließlich eine, der Seitenflächen stoffschlüssig mit dem elektrisch isolierenden Träger verbunden ist. Vorzugsweise ist die gesamte Seitenfläche des Kühlkörpers mit dem Träger verbunden.

In einer Weiterbildung sind an der parallel zu der mit dem Kühlkörper verbundenen Seitenfläche des Kühlkörpers sowohl die Zulaufleitung als auch die Ablaufleitung ausgebildet bzw. angeflanscht.

In einer Ausführungsform ist der Träger blockförmig vorzugsweise quaderförmig ausgebildet, wobei der Träger zwei Deckflächen und vier Seitenflächen aufweist. Die beiden Deckflächen des Trägers sind parallel zueinander angeordnet und vorzugsweise gleich groß ausgebildet. Die beiden Deckflächen des Trägers weisen jeweils eine größere Fläche auf als jede der Seitenflächen. Genau eine der beiden Deckflächen des Trägers ist mit eine der Seitenflächen des Kühlkörpers verbunden.

In einer Weiterbildung ist die mit der Seitenfläche des Kühlkörpers verbundene Deckfläche des Trägers in einer ersten Näherung gleich groß oder genau gleich groß ausgebildet. In einer anderen Weiterbildung ist die mit dem Kühlköper verbundenen Deckfläche größer als die Seitenfläche. Vorzugsweise weist die Deckfläche eine Fläche zwischen 100% und 180 % der Seitenfläche des Kühlkörpers auf.

Als Die wird eine ungehäuste integrierte Schaltung auf einem Halbleitersubstrat, also ein vereinzelter Waferabschnitt, d.h. ein Teil einer Halbleiterscheibe mit einer integrierten Schaltung bezeichnet.

Es versteht sich, dass die Unterseiten der Dies, also die Rückseitenanschlüsse, auf demselben Potential liegen und insbesondere elektrisch leitfähig verbunden sind, da die Die-Unterseiten jeweils mit einer Oberfläche desselben Kühlkörpers leitfähig verbunden sind, z.B. mittels einer Lot- Press- oder Sinterverbindung oder einer beliebigen anderen Kontaktierungstechnologie.

Die Anschlusskontakte der Dies sind mit den Anschlusspins verschaltet, wobei die elektrische Verschaltung der Anschlusskontakte der Dies, also insbesondere des Kühlkörpers für den Rückseitenkontakt und der Vorderseitenkontakte, mit den Anschlusspins erfolgt beispielsweise mittels Bonddrähten; Pressvorrichtung oder mittels bandähnlicher Strukturen, wie Kupferbändern (copper ribbon bonding) oder sonstige Verbindungstechnologie wobei die Verbindungsdrähte bzw. Bänder über den Träger verlaufen und von der Vergussmasse umschlossen sind. Alternativ kann eine Verbindung oder können mehrere Verbindungen auch durch den Träger hindurchgeführt werden.

In einer Weiterbildung sind die Vorderseitenkontakte der beiden Dies miteinander elektrisch verschaltet, wobei vorzugsweise die beiden Vorderseitenkontakte jeweils mittels eines eigenen Bonds über den Träger zu dem gleichen Anschlusspin verbunden sind. Der andere Anschlusspin ist mit einem extra Bond über den Träger mit dem Kühlkörper und hierdurch mit den beiden Rückseitenkontakten der beiden Dies verschaltet. Hierdurch sind die beiden Dies elektrisch parallel verschaltet.

In einer anderen Ausführungsform sind die beiden Rückseiten der Dies mittels der Kühlstruktur d.h. mittels der Zulaufleitung und / oder der Ablaufleitung elektrisch angeschlossen, wobei jede Oberseite der beiden Dies jeweils über den Träger hinweg mittels eines Bonds zu einem Anschlusspin verschaltet ist. Anders ausgedrückt, die Oberseiten der beiden Dies sind mit unterschiedlichen Anschlusspins elektrisch verschaltet.

Ein Vorteil des Halbleiterbauteils ist, dass es ohne Leadframe auskommt. Anders ausgedrückt, das Die wird unmittelbar auf dem Kühlkörper ausgebracht. Des Weiteren ermöglicht die Struktur das Herstellen von sehr kompakten und leistungsfähigen Halbleiterbauteilen, da insbesondere mechanische Belastungen der Dies vermieden werden und eine effektive Kühlung realisiert wird. Hierdurch werden die Ausbeute und die Zuverlässigkeit des Aufbaus erhöht und die Kosten reduziert.

In einer ersten Ausführungsform weisen die beiden Dies denselben thermischen Ausdehnungskoeffizienten auf. Beispielsweise handelt es sich um Bauteile aus demselben Material bzw. einem ähnlichen Material, z.B. GaAs. In einer Weiterbildung sind die Dies gleichartig ausgebildet, beispielsweise handelt es sich um gleichartige Dioden. Gleichartig bedeutet, dass es sich im Wesentlichen um dieselben Bauteile handelt, also Bauteile aus demselben Material und mit derselben Struktur, wobei produktionsbedingte oder entsprechende Abweichungen immer noch als gleichartig bezeichnet werden.

In einer alternativen Ausführungsform weisen die beiden Dies sich voneinander unterscheidende thermische Ausdehnungskoeffizienten auf. Beispielsweise bestehen die Dies aus unterschiedlichen Materialien oder unterschiedlichen Materialzusammensetzungen und / oder es handelt sich um unterschiedliche Bauteile, z.B. eine Diode einerseits und einen IGBT andererseits oder sonstige übliche Kombination von Halbleiterbauelementen.

In einer Weiterbildung sind mindestens die beiden Dies jeweils als Dioden ausgebildet. Vorzugsweise weisen die beiden Dies die gleichen typischen elektrischen Daten auf.

In einer Weiterbildung ändert sich der thermische Ausdehnungskoeffizient des Kühlkörpers von der Unterseite zu der Oberseite, wobei die Änderung kontinuierlich oder schrittweise mit mindestens einem Schritt erfolgt.

Die Änderung des thermischen Ausdehnungskoeffizienten wird beispielsweise durch eine Änderung der Materialzusammensetzung des Kühlkörpers erreicht. Beispielsweise wird der Anteil einer Materialkomponente reduziert und / oder der Anteil einer anderen Materialkomponente erhöht. Insbesondere wird die Stöchiometrie verändert.

In einer anderen Weiterbildung weist das Halbleiterbauteil mindestens einen weiteren Kühlkörper auf.

Der weitere Kühlkörper weist eine Oberseite, eine Unterseite, die Oberseite mit der Unterseite verbindende Seitenflächen und eine innerhalb des Kühlkörpers verlaufenden Kühlstruktur mit einer Zulaufleitung sowie einer Ablaufleitung für ein Kühlmedium auf.

Der weitere Kühlkörper umfasst oder besteht aus einem elektrisch leitfähigen Material mit einem dritten thermischen Ausdehnungskoeffizienten an der Oberseite und einem vierten thermischen Ausdehnungskoeffizienten an der Unterseite. In einer Weiterbildung sind die beiden Ausdehnungskoeffizienten genau gleich groß.

Auf der Oberseite und der Unterseite des weiteren Kühlkörpers ist jeweils ein Die angeordnet und elektrisch leitfähig mit dem weiteren Kühlkörper verbunden ist.

Der thermische Ausdehnungskoeffizient der Oberseite und der Unterseite d.h. der dritte und der vierte Ausdehnungskoeffizient des weiteren Kühlkörpers entsprechen jeweils dem thermischen Ausdehnungskoeffizienten des darauf angeordneten Dies.

Es sei angemerkt, dass mit dem Begriff "entspricht" ein Unterschied zwischen den beiden Ausdehnungskoeffizienten kleiner als 5% oder kleiner als 8% umfasst ist.

In einer Weiterbildung ist der Ausdehnungskoeffizient auf der Unterseite bzw. auf der Oberseite des Kühlkörpers d.h. der dritte Ausdehnungskoeffizient und der vierte Ausdehnungskoeffizient sind genau gleich wie der Ausdehnungskoeffizient des jeweiligen Dies.

Vorzugsweise weichen der dritte Ausdehnungskoeffizient und der vierte Ausdehnungskoeffizient von dem thermischen Ausdehnungskoeffizienten der jeweils darauf angeordneten Dies um höchstens 10% oder um höchstens 20% ab.

Der weitere Kühlkörper ist mit einer der Seitenflächen in einem Abstand zu dem ersten Kühlkörper an dem elektrisch isolierenden Träger befestigt.

An dem Träger sind mindestens zwei weitere Anschlusspins befestigt und der weitere Kühlkörper sind mit den darauf angeordneten Dies und einem Teil der weiteren Anschlusspins von der Vergussmasse umschlossen.

Der Halbleiterkörper weist somit zwei oder mehr Kühlkörper auf, wobei die Kühlkörper alle zueinander beabstandet an dem gemeinsamen Träger angebracht sind. Auch die Anschlusspins zum Verschalten sind an dem Träger angebracht.

Es versteht sich, dass auch die Anschlusspins jeweils zueinander sowie zu den Kühlkörpern beabstandet angeordnet sind. Beispielsweise sind die mindestens zwei Kühlkörper auf einer Seite eines länglichen Trägers in Abständen aufgereiht, während die Anschlusspins auf einer gegenüberliegenden Seite des Trägers ebenfalls in Abständen aufgereiht sind.

Die erfindungsgemäße Struktur mit vier Dies, angeordnet auf zwei Kühlkörper, ermöglicht beispielsweise eine besonders kompakte und belastbare Ausführung eines Vollbrücken-Gleichrichters oder von integrierten Schaltungen mit Sensoren.

Es versteht sich, im Falle eines Gleichrichters alle Dies als möglichst gleichartige Dioden oder Thyristoren, GTOs ausgestaltet sind und die Gleichspannung über die beiden Kühlkörper abgegriffen wird.

Die Vergussmasse umschließt die Kühlkörper, die Dies sowie mindestens einen Teil der Anschlusspins und des Trägers. Gegebenenfalls umschließt die Vergussmasse auch einen Teil der Zulauf- und Ablaufleitung. Bevorzugt umschließt die Vergussmasse insbesondere auch alle Bonddrähte. Kupferbänder etc., für die Verschaltung der Dies mit den Pins.

In einer weiteren Ausführungsform ist mindestens ein Die eine Diode. In einer Ausführungsform mit zwei Kühlkörpern sind vorzugsweise alle Dies Dioden, so dass mittels einer entsprechenden Verschaltung der Dioden bzw. Anschlusspins bzw. Kühlkörper ein Vollbrücken- Gleichrichter realisiert werden. Es versteht sich, dass auch andere Bauelemente insbesondere integrierte Schaltungen auf den Kühlkörpern anordnen lassen. Insbesondere lassen sich Dioden mit anderen passiven Bauelementen anordnen.

In einer anderen Ausführungsform ist mindestens ein Die ein IGBT. Bevorzugt ist beispielsweise der auf der Oberseite angeordnete Die als Diode und der auf der Unterseite angeordnete Die als IGBT ausgebildet. Es versteht sich, dass auch andere Bauelemente insbesondere integrierte Schaltungen auf den Kühlkörpern anordnen lassen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine Seitenansicht einer Ausführungsform eines gehäusten Halbleiterbauteils,
- Figur 2: eine Aufsicht auf eine weitere Ausführungsform des gehäusten Halbleiterbauteils,
- Figur 3: eine Ansicht zweier Kühlkörper in einer weiteren Ausführungsform,
- Figur 4: eine Ansicht eines Kühlkörpers in einer weiteren Ausführungsform.

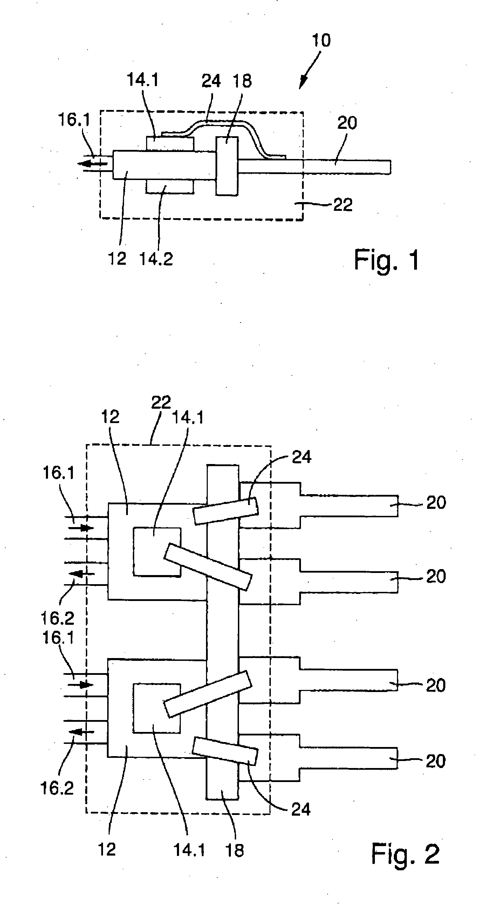

Die Abbildung der Figur 1 zeigt eine seitliche Ansicht eines gehäusten Halbleiterbauteils 10 mit einem aus einem elektrisch leitfähigen Material bestehenden Kühlkörper 12 und zwei Dies 14.1 und 14.2. Der erste Die 14.1 ist direkt auf einer Oberseite des Kühlkörpers 12 angeordnet, während der zweite Die 14.2 direkt auf einer der Oberseite gegenüberliegenden Unterseite des Kühlkörpers 12 angeordnet ist.

Beide Dies 14 sind jeweils mit einer Unterseite elektrisch leitfähig mit dem Kühlkörper 12 verbunden, wobei der Kühlkörper aus einem elektrisch leitfähigen Material besteht. Die Unterseiten der Dies liegen somit auf demselben Potential, z.B. einem Massepotential.

Der Kühlkörper 12 weist außerdem an Oberseite sowie an der Unterseite einen thermischen Ausdehnungskoeffizienten auf, wobei der thermische Ausdehnungskoeffizient jeweils dem thermischen Ausdehnungskoeffizienten des angrenzenden Dies entspricht oder gleich oder einen Unterschied kleiner akls 10% oder als 20% aufweist.

Eine Kühlstruktur innerhalb des Kühlkörpers 12 ist mit mindestens einer Zulauf- und mindestens einer Ablaufleitung 16 für ein Kühlmittel verbunden.

Der Kühlkörper 12 ist mit einer Seitenfläche an einem Träger 18 aus einem elektrisch isolierenden Material angeordnet. Auf einer von dem Kühlkörper 12 abgewandten Seite des Trägers 18 sind zwei Anschlusspins 20 angeordnet, wobei der Kühlkörper 12 mit einem der Anschlusspins 20 verschaltet ist, während ein Oberseitenanschlusskontakt jedes Dies 14.1 und 14.2 jeweils mit dem anderen Anschlusspin 20, z.B. mittels eines Bonddrahts oder eines Metallbands, verschaltet ist. In der Abbildung der Figur 1 ist der Übersichtlichkeit halber lediglich ein Anschlussdraht 24 exemplarisch für den Oberseitenanschlusskontakt des Dies 14.1 dargestellt. Es versteht sich, dass auch der Oberseitenanschlusskontakt des Dies 14.2 mittels einer elektrisch leitfähigen Verbindung mit einem Anschlusspin verschaltet ist.

Eine Vergussmasse 22 umschließt den Kühlkörper 12, die Dies 14.1, 14.2, den Träger 18 sowie jeweils einen Teil der Zulauf- und der Ablaufleitung 16 und einen an den Träger angrenzenden Teil jedes Anschlusspins 20.

In der Abbildung der Figur 2 ist eine weitere Ausführungsform dargestellt. Im Folgenden werden nur die Unterschiede zu der Abbildung der Figur 1 erläutert.

Das Halbleiterbauteil 10 umfasst zwei Kühlkörper 12.1 und 12.2 die zueinander beabstandet an dem Träger 18 angeordnet sind, wobei auf jeder Kühlkörperoberseite und jeder Kühlkörperunterseite ein Die angeordnet ist und die jeweilige Seite bzw. Fläche des Kühlkörpers 12.1 bzw. 12.2 denselben thermischen Ausdehnungskoeffizienten wie der darauf angeordnete Die aufweist. An dem Träger 12 sind außerdem vier Anschlusspins 20 angeordnet.

Eine erste Ausführungsform einer Verschaltung der Kühlkörper bzw. Unterseitenkontakte der Dies sowie der Oberseitenkontakte der Dies mit den Anschlusspins 20 mittels Kupferbändern 24 in der Abbildung der Figur 2 dargestellt. Es versteht sich, dass sich die Verschaltungsstruktur und Art nach den Dies und der Anwendung richtet.

Jeder Kühlkörper weist eine eigene Zulauf- und Ablaufleitung auf, so dass der Kühlmittelfluss quasi parallel verläuft.

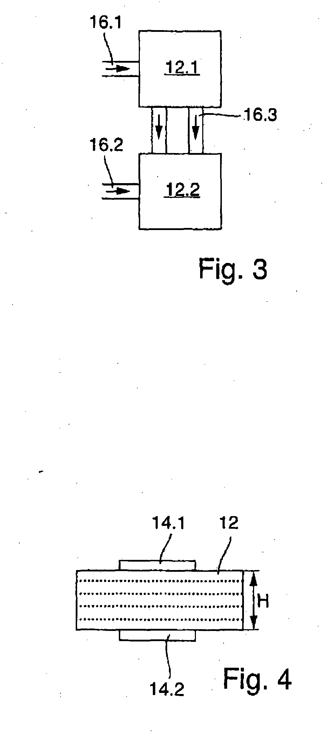

In der Abbildung der Figur 3 ist eine weitere Ausführungsform der Kühlmittelführung schematisch dargestellt.

Alternativ weist einer der Kühlkörper 12.1 die Zulaufleitung 16.1 und der andere Kühlkörper 12.2 die Ablaufleitung 16.2 auf, wobei das Kühlmittel über mindestens eine Verbindungsleitung 16.3 von dem einen Kühlkörper 12.1 zu dem anderen Kühlkörper 12.2 gelangt. In einer bevorzugten Ausführungsform bestehen die Verbindungsleitungen 16.3 aus einem elektrisch isolierenden Material.

In der Abbildung der Figur 4 ist eine weitere Ausführungsform des Kühlkörpers 12 dargestellt, wobei im Folgenden nur die Unterschiede zu der Ausführungsform In Figur 1 erläutert werden.

Auf der Oberseite des Kühlkörpers 12 ist ein erster Die 14.1 mit einem ersten thermischen Ausdehnungskoeffizienten, z.B. eine Diode, angeordnet. Auf der Unterseite des Kühlkörpers 12 ist ein zweiter Die 14.2 mit einem sich von dem ersten thermischen Ausdehnungskoeffizienten unterscheidenden zweiten thermischen Ausdehnungskoeffizienten angeordnet.

Ein Übergang von dem zweiten thermischen Ausdehnungskoeffizienten an der Unterseite des Kühlkörpers 12 zu dem ersten thermischen Ausdehnungskoeffizienten an der Oberseite des Kühlkörpers 12 erfolgt schrittweise entlang einer Höhe H des Kühlkörpers, so dass der Kühlkörper mehrere Schichten mit jeweils unterschiedlichen thermischen Ausdehnungskoeffizienten aufweist.

## Patentansprüche

1. Gehäustes Halbleiterbauteil (10), aufweisend einen Kühlkörper (12), wobei
- der Kühlkörper (12) eine Oberseite, eine Unterseite, die Oberseite mit der Unterseite verbindende Seitenflächen und eine innerhalb des Kühlkörpers (12) verlaufenden Kühlstruktur mit einer Zulaufleitung (16.1) sowie einer Ablaufleitung (16.2) für ein Kühlmedium aufweist und aus einem elektrisch leitfähigen Material mit einem ersten thermischen Ausdehnungskoeffizienten an der Oberseite und einem zweiten thermischen Ausdehnungskoeffizienten an der Unterseite besteht,
- auf der Oberseite und der Unterseite des Kühlkörpers (12) jeweils ein Die (14.1, 14.2) angeordnet und elektrisch leitfähig mit dem Kühlkörper (12) verbunden ist,
- der thermische Ausdehnungskoeffizient der Oberseite und der Unterseite des Kühlkörpers (12) jeweils dem thermischen Ausdehnungskoeffizienten des darauf angeordneten Dies (14.1, 14.2) entspricht oder um höchstens 10% oder um höchsten 20% von dem thermischen Ausdehnungskoeffizienten des darauf angeordneten Dies (14.1, 14.2) abweicht,
- der Kühlkörper (12) mit einer der Seitenflächen an einem elektrisch isolierenden Träger (18) befestigt ist,
- an dem Träger (18) zwei Anschlusspins (20) befestigt sind und
- der Kühlkörper (12) mit den Dies (14.1, 14.2) und einem Teil der Anschlusspins (20) von einer Vergussmasse (22) umschlossen sind.

2. Gehäustes Halbleiterbauteil (10) nach Anspruch 1, **dadurch gekennzeichnet, dass** die beiden Dies (14.1, 14.2) denselben thermischen Ausdehnungskoeffizienten aufweisen.

3. Gehäustes Halbleiterbauteil (10) nach Anspruch 1, **dadurch gekennzeichnet, dass** die beiden Dies (14.1, 14.2) sich voneinander unterscheidende thermische Ausdehnungskoeffizienten aufweisen.

4. Gehäustes Halbleiterbauteil (10) nach Anspruch 3, **dadurch gekennzeichnet, dass** sich der thermische Ausdehnungskoeffizient des Kühlkörpers (12) von der Unterseite zu der Oberseite ändert, wobei die Änderung kontinuierlich oder schrittweise mit mindestens einem Schritt erfolgt.

5. Gehäustes Halbleiterbauteil (10) nach einem der vorstehenden Ansprüche, **dadurch gekennzeichnet, dass** das Halbleiterbauteil (10) mindestens einen weiteren Kühlkörper (12) aufweist, wobei
- der weitere Kühlkörper (12) eine Oberseite, eine Unterseite, die Oberseite mit der Unterseite verbindende Seitenflächen und eine innerhalb des Kühlkörpers (12) verlaufenden Kühlstruktur mit einer Zulaufleitung (16.1) sowie einer Ablaufleitung (16.2) für ein Kühlmedium aufweist und aus einem elektrisch leitfähigen Material mit einem dritten thermischen Ausdehnungskoeffizienten an der Oberseite und einem vierten thermischen Ausdehnungskoeffizienten an der Unterseite besteht,
- auf der Oberseite und der Unterseite des weiteren Kühlkörpers (12) jeweils ein Die (14.1, 14.2) angeordnet und elektrisch leitfähig mit dem weiteren Kühlkörper (12) verbunden ist,
- der thermische Ausdehnungskoeffizient der Oberseite und der Unterseite des weiteren Kühlkörpers (12) jeweils dem thermischen Ausdehnungskoeffizienten des darauf angeordneten Dies (14.1, 14.2) entsprechen oder um höchstens 10% oder um höchsten 20% von dem thermischen Ausdehnungskoeffizienten des darauf angeordneten Dies (14.1, 14.2) abweichen,
- der weitere Kühlkörper (12) mit einer der Seitenflächen in einem Abstand zu dem ersten Kühlkörper (12) an dem elektrisch isolierenden Träger (18) befestigt ist,
- an dem Träger (18) mindestens zwei weitere Anschlusspins (20) befestigt sind und
- der weitere Kühlkörper (12) mit den darauf angeordneten Dies (14.1, 14.2) und einem Teil der weiteren Anschlusspins (20) von der Vergussmasse (22) umschlossen sind.

6. Gehäustes Halbleiterbauteil (10) nach einem der vorstehenden Ansprüche, **dadurch gekennzeichnet, dass** mindestens ein Die (14.1, 14.2) eine Diode ist.

7. Gehäustes Halbleiterbauteil (10) nach einem der vorstehenden Ansprüche, **dadurch gekennzeichnet, dass** mindestens ein Die (14.1, 14.2) ein IGBT ist.

8. Gehäustes Halbleiterbauteil (10) nach einem der Ansprüche 1 bis 6, **dadurch gekennzeichnet, dass** mindestens die beiden Dies (14.1, 14.2) jeweils als Dioden ausgebildet sind.

9. Gehäustes Halbleiterbauteil (10) nach einem der Ansprüche 1 bis 6 oder 8, **dadurch gekennzeichnet, dass** mindestens die beiden Dies (14.1, 14.2) parallel verschaltet sind.

10. Gehäustes Halbleiterbauteil (10) nach einem der vorstehenden Ansprüche, **dadurch gekennzeichnet, dass** genau eine der Seitenfläche des Kühlkörpers (12) mit einer Deckfläche des Trägers (18) stoffschlüssig verbunden ist.

11. Gehäustes Halbleiterbauteil (10) nach Anspruch 10, **dadurch gekennzeichnet, dass** die Deckfläche des Trägers (18) eine größere Fläche das die Seitenfläche des Kühlkörpers (12) aufweist.

## Claims

1. Housed semiconductor component (10), comprising a heat sink (12), wherein
- the heat sink (12) has an upper side, a lower side, side surfaces connecting the upper side with the lower side and a cooling structure, which extends within the heat sink (12), with a feed line (16.1) as well as a drain line (16.2) for a cooling medium, the heat sink consisting of an electrically conductive material with a first thermal coefficient of expansion at the upper side and a second thermal coefficient of expansion at the lower side,
- a respective die (14.1, 14.2) is arranged on each of the upper side and the lower side of the heat sink (12) and is electrically conductively connected with the heat sink (12),
- the thermal coefficient of expansion of each of the upper side and the lower side of the heat sink (12) corresponds with the thermal coefficient of expansion of the die (14.1, 14.2) arranged thereon or differs by at most 10% or at most 20% from the thermal coefficient of expansion of the die (14.1, 14.2) arranged thereon,
- the heat sink (12) is fastened by one of the side surfaces to an electrically insulating carrier (18),
- two terminal pins (20) are secured to the carrier (18) and
- the heat sink (12) together with the dies (14.1, 14.2) and a part of the terminal pins (20) are surrounded by an encapsulating material (22).

2. Housed semiconductor component (10) according to claim 1, **characterised in that** the two dies (14.1, 14.2) have the same thermal coefficients of expansion.

3. Housed semiconductor component (10) according to claim 1, **characterised in that** the two dies (14.1, 14.2) have thermal coefficients of expansion differing from one another.

4. Housed semiconductor component (10) according to claim 3, **characterised in that** the thermal coefficient of expansion of the heat sink (12) changes from the lower side to the upper side, wherein the change takes place continuously or in stepped manner with at least one step.

5. Housed semiconductor component (10) according to any one of the preceding claims, **characterised in that** the semiconductor component (10) comprises at least one further heat sink (12), wherein
- the further heat sink (12) has an upper side, a lower side, side surfaces connecting the upper side with the lower side and a cooling structure, which extends within the heat sink (12), with a feed line (16.1) as well as a drain line (16.2) for a cooling medium, the further heat sink consisting of an electrically conductive material with a third thermal coefficient of expansion at the upper side and a fourth thermal coefficient of expansion at the lower side,
- a respective die (14.1, 14.2) is arranged on each of the upper side and the lower side of the further heat sink (12) and is electrically conductively connected with the further heat sink (12),
- the thermal coefficient of expansion of each of the upper side and the lower side of the further heat sink (12) corresponds with the thermal coefficient of expansion of the die (14.1, 14.2) arranged thereon or differs by at most 10% or at most 20% from the thermal coefficient of expansion of the die (14.1, 14.2) arranged thereon,
- the further heat sink (12) is fastened by one of the side surfaces to the electrically insulating carrier (18) at a spacing from the first heat sink (12),
- at least two further terminal pins (20) are secured to the carrier (18) and
- the further heat sink (12) together with the dies (14.1, 14.2) and a part of the further terminal pins (20) are surrounded by an encapsulating material (22).

6. Housed semiconductor component (10) according to any one of the preceding claims, **characterised in that** at least one die (14.1, 14.2) is a diode.

7. Housed semiconductor component (10) according to any one of the preceding claims, **characterised in that** at least one die (14.1, 14.2) is an IGBT.

8. Housed semiconductor component (10) according to any one of claims 1 to 6, **characterised in that** at least the two dies (14.1, 14.2) are respectively configured as diodes.

9. Housed semiconductor component (10) according to any one of claims 1 to 6 or 8, **characterised in that** at least the two dies (14.1, 14.2) are connected in parallel.

10. Housed semiconductor component (10) according to any one of the preceding claims, **characterised in that** exactly one of the side surfaces of the heat sink (12) is connected by material couple with a cover surface of the carrier (18).

11. Housed semiconductor component (10) according to claim 10, **characterised in that** the cover surface of the carrier (18) has a greater area than the side surface of the heat sink (12).

## Revendications

1. Composant semi-conducteur en boîtier (10) comportant un corps de refroidissement (12), dans lequel
- le corps de refroidissement (12) présente une face supérieure, une face inférieure, les faces latérales reliant la face supérieure à la face inférieure et une structure de refroidissement dotée d'une conduite d'admission (16.1) et d'une conduite d'évacuation (16.2) pour un fluide de refroidissement courant à l'intérieur du corps de refroidissement (12), et est constitué d'un matériau électro-conducteur avec un premier coefficient de dilatation thermique sur la face supérieure et un deuxième coefficient de dilatation thermique sur la face inférieure,
- une puce (14.1, 14.2) est disposée sur chacune des faces supérieure et inférieure du corps de refroidissement (12) et reliée de manière électro-conductrice au corps de refroidissement (12),
- le coefficient de dilatation thermique des faces supérieure et inférieure du corps de refroidissement (12) correspond respectivement au coefficient de dilatation thermique de la puce (14.1, 14.2) disposée dessus ou diverge de 10% maximum ou de 20% maximum du coefficient de dilatation thermique de la puce (14.1, 14.2) disposée dessus,
- le corps de refroidissement (12) est fixé par une des faces latérales à un support (18) isolant électriquement,
- deux broches de connexion (20) sont fixées sur le support (18) et
- le corps de refroidissement (12) avec les puces (14.1, 14.2) et une partie des broches de connexion (20) est entouré par une masse de scellement (22).

2. Composant semi-conducteur en boîtier (10) selon la revendication 1, **caractérisé en ce que** les deux puces (14.1, 14.2) présentent le même coefficient de dilatation thermique.

3. Composant semi-conducteur en boîtier (10) selon la revendication 1, **caractérisé en ce que** les deux puces (14.1, 14.2) présentent des coefficients de dilatation thermique différents l'un de l'autre.

4. Composant semi-conducteur en boîtier (10) selon la revendication 3, **caractérisé en ce que** le coefficient de dilatation thermique du corps de refroidissement (12) varie de la face inférieure à la face supérieure, la variation se faisant en continu ou par étapes avec au moins une étape.

5. Composant semi-conducteur en boîtier (10) selon une des revendications précédentes, **caractérisé en ce que** ce composant semi-conducteur (10) comporte au moins un corps de refroidissement supplémentaire (12),
- le corps de refroidissement supplémentaire (12) présentant une face supérieure, une face inférieure, les faces latérales reliant la face supérieure à la face inférieure et une structure de refroidissement dotée d'une conduite d'admission (16.1) et d'une conduite d'évacuation (16.2) pour un fluide de refroidissement courant à l'intérieur du corps de refroidissement (12), et étant constitué d'un matériau électro-conducteur avec un troisième coefficient de dilatation thermique sur la face supérieure et un quatrième coefficient de dilatation thermique sur la face inférieure,
- une puce (14.1, 14.2) étant disposée sur chacune des faces supérieure et inférieure du corps de refroidissement supplémentaire (12) et reliée de manière électro-conductrice au corps de refroidissement supplémentaire (12),
- le coefficient de dilatation thermique des faces supérieure et inférieure du corps de refroidissement supplémentaire (12) correspondant respectivement au coefficient de dilatation thermique de la puce (14.1, 14.2) disposée dessus ou divergeant de 10% maximum ou de 20% maximum du coefficient de dilatation thermique de la puce (14.1, 14.2) disposée dessus,
- le corps de refroidissement supplémentaire (12) étant fixé par une des faces latérales au support (18) isolant électriquement à une certaine distance du premier corps de refroidissement (12),
- au moins deux broches de connexion supplémentaires (20) étant fixées sur le support (18) et
- le corps de refroidissement supplémentaire (12) avec les puces (14.1, 14.2) disposées dessus et une partie des broches de connexion supplémentaires (20) étant entouré par la masse de scellement (22).

6. Composant semi-conducteur en boîtier (10) selon une des revendications précédentes, **caractérisé en ce qu'**au moins une puce (14.1, 14.2) est une diode.

7. Composant semi-conducteur en boîtier (10) selon une des revendications précédentes, **caractérisé en ce qu'**au moins une puce (14.1, 14.2) est un IGBT.

8. Composant semi-conducteur en boîtier (10) selon une des revendications 1 à 6, **caractérisé en ce qu'**au moins les deux puces (14.1, 14.2) sont configurées respectivement comme des diodes.

9. Composant semi-conducteur en boîtier (10) selon une des revendications 1 à 6 ou 8, **caractérisé en ce qu'**au moins les deux puces (14.1, 14.2) sont connectées en parallèle.

10. Composant semi-conducteur en boîtier (10) selon une des revendications précédentes, **caractérisé en ce qu'**exactement une des faces latérales du corps de refroidissement (12) est reliée par combinaison de matériaux avec la face de recouvrement du support (18).

11. Composant semi-conducteur en boîtier (10) selon la revendication 10, **caractérisé en ce que** la face de recouvrement du support (18) présente une plus grande superficie que la face latérale du corps de refroidissement (12).
